# EUROPEAN PATENT APPLICATION

(11) **EP 4 629 771 A1**
(43) Date of publication of application: **08.10.2025**
(21) Application number: 25153527.4
(22) Date of filing: 23.01.2025
(51) Int. Cl.: H10B 53/30, H10D 1/68

(54) **SEMICONDUCTOR MEMORY DEVICE**

(30) Priority: 01.04.2024 KR 20240044224
(71) Applicant: Samsung Electronics Co., Ltd., Suwon-si, Gyeonggi-do 16677 (KR)
(72) Inventor: BAEK, Ji Ye, 16677 Suwon-si, Gyeonggi-do (KR); MIN, Jong Yeong, 16677 Suwon-si, Gyeonggi-do (KR); LEE, Ye Seul, 16677 Suwon-si, Gyeonggi-do (KR); LEE, Jin Wook, 16677 Suwon-si, Gyeonggi-do (KR); JEON, In Tak, 16677 Suwon-si, Gyeonggi-do (KR)
(74) Representative: Kuhnen & Wacker Patent- und Rechtsanwaltsbüro PartG mbB

(57) **Abstract**

A semiconductor memory device is provided. The semiconductor memory device comprising a first electrode (301) and a second electrode (302) spaced apart from each other, and a dielectric film structure (400) between the first electrode and the second electrode, wherein the dielectric film structure includes a first ferroelectric material film (401), a first insertion film (901), a second ferroelectric material film (402), and a first paraelectric material film (501), the first ferroelectric material film is closer than the first paraelectric material film to the first electrode, and a dielectric constant of the first insertion film is greater than respective dielectric constants of the first and second ferroelectric material films.

## Description

### BACKGROUND

The present disclosure relates to a semiconductor memory device.

As semiconductor devices have become more capable and highly integrated, design rules have been continuously shrinking. This trend is also evident in Dynamic Random-Access Memory (DRAM), a type of memory semiconductor device. Each cell in a DRAM device must have a certain level of capacitance to function properly.

Increasing capacitance enhances the amount of charge stored in capacitors, thereby improving the refresh characteristics of semiconductor devices. Enhanced refresh characteristics can lead to better yields in semiconductor devices.

With the down-scaling of integrated circuit devices, the space occupied by capacitors has also decreased. Capacitors consist of upper and lower electrodes with a dielectric film interposed therebetween, using dielectric materials with a high dielectric constant to achieve high capacitance. It is desirable to reduce the leakage current in capacitors while minimizing the decrease in capacitance.

### SUMMARY

Aspects of the present disclosure provide a semiconductor memory device that includes a capacitor capable of improving device performance and reliability.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

According to some embodiments of the present disclosure, there is provided a semiconductor memory device comprising a first electrode and a second electrode spaced apart from each other; and a dielectric film structure between the first electrode and the second electrode, wherein the dielectric film structure includes a first ferroelectric material film, a first insertion film, a second ferroelectric material film, and a first paraelectric material film, the first ferroelectric material film is closer than the first paraelectric material film to the first electrode, and a dielectric constant of the first insertion film is greater than respective dielectric constants of the first and second ferroelectric material films.

According to the aforementioned and other embodiments of the present disclosure, there is provided a semiconductor memory device comprising a first electrode and a second electrode spaced apart from each other, and a dielectric film structure between the first and second electrodes and including a first dielectric film, a first insertion film, a second dielectric film, and a third dielectric film, wherein the first dielectric film is closer than the third dielectric film to the first electrode. The first and second dielectric films include crystals with an orthorhombic crystal structure, and the first insertion film includes a material with a dielectric constant that is greater than respective dielectric constants of the first, second, and third dielectric films.

According to the aforementioned and other embodiments of the present disclosure, there is provided a semiconductor memory device comprising a transistor on a substrate, and a capacitor electrically connected to the transistor, wherein the capacitor includes a lower electrode, a dielectric film structure on the lower electrode, and an upper electrode on the dielectric film structure, the dielectric film structure includes a first ferroelectric material film, an insertion film, a second ferroelectric material film, and a paraelectric material film, the first and second ferroelectric material films include a material with a greater dielectric constant than respective dielectric constants of the paraelectric material film, and the insertion film includes an oxide of at least one of zirconium (Zr), titanium (Ti), tantalum (Ta), niobium (Nb), lanthanum (La), barium (Ba), and vanadium (V), and is in direct contact with the first and second ferroelectric material films.

It should be noted that the effects of the present disclosure are not limited to those described above, and other effects of the present disclosure will be apparent from the following description.

However, aspects of the present disclosure are not restricted to those set forth herein. The above and other aspects of the present disclosure will become more apparent to one of ordinary skill in the art to which the present disclosure pertains by referencing the detailed description of the present disclosure given below.

### BRIEF DESCRIPTION OF THE DRAWINGS

The above and other aspects and features of the present disclosure will become more apparent by describing in detail example embodiments thereof with reference to the attached drawings, in which:
FIG. 1 is a cross-sectional illustrating a semiconductor memory device according to some embodiments. FIG. 2 is an enlarged cross-sectional view of part A of FIG. 1.
FIG. 3 is a cross-sectional view illustrating a semiconductor memory device according to some embodiments.
FIG. 4 is a cross-sectional view illustrating a semiconductor memory device according to some embodiments.
FIG. 5 is a cross-sectional view illustrating a semiconductor memory device according to some embodiments.
FIG. 6 is a cross-sectional view illustrating a semiconductor memory device according to some embodiments.
FIG. 7 is a cross-sectional view illustrating a semiconductor memory device according to some embodiments.
FIG. 8 is a layout view of a semiconductor memory device according to other embodiments.
FIG. 9 is a layout view illustrating wordlines and a cell active area film of FIG. 8.
FIG. 10 is a cross-sectional view taken along A - A of FIG. 8.
FIGS. 11 and 12 are diagrams illustrating a semiconductor memory device according to some embodiments.
FIG. 13 is a layout view illustrating a semiconductor memory device according to some embodiments.
FIG. 14 is a perspective view illustrating the semiconductor memory device of FIG. 13.
FIG. 15 is a cross-sectional view taken along lines B-B and C-C of FIG. 13.
FIG. 16 is a layout view illustrating a semiconductor memory device according to some embodiments.
FIG. 17 is a perspective view illustrating the semiconductor memory device of FIG. 16.
FIG. 18 is a layout view illustrating a semiconductor memory device according to some embodiments.
FIGS. 19, 20, 21, 22, and 23 are cross-sectional views illustrating intermediate stages of a method of fabricating a semiconductor memory device according to some embodiments.

### DETAILED DESCRIPTION

In this specification, terms such as "first," "second," etc., are used to describe various devices or components, but these devices or components are not limited by these terms. These terms serve merely to distinguish one device or component from another. Therefore, a "first" device or component mentioned herein may potentially be a "second" device or component within the technical scope of the present disclosure.

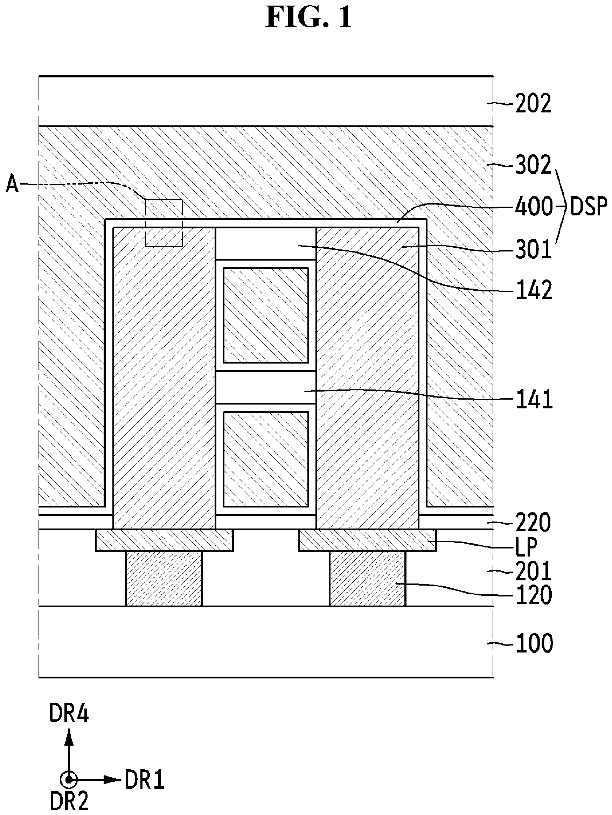

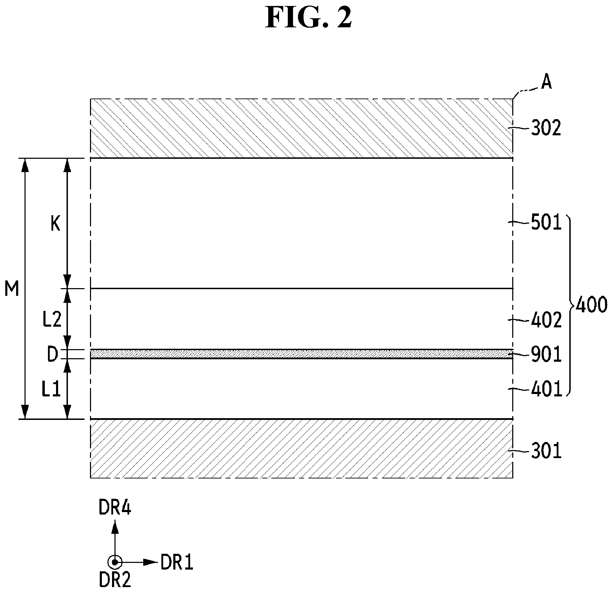

FIG. 1 is a cross-sectional illustrating a semiconductor memory device according to some embodiments. FIG. 2 is an enlarged cross-sectional view of part A of FIG. 1.

Referring to FIGS. 1 and 2, the semiconductor memory device according to some embodiments may include a substrate 100, a first interlayer insulating film 201, storage contacts 120, landing pads LP, an etch stop film 220, a data storage pattern DSP, a lower support pattern 141, an upper support pattern 142, and a second interlayer insulating film 202.

The substrate 100 may be a bulk silicon (Si) or Si-on-insulator (SOI) substrate. In some embodiments, the substrate 100 may be a Si substrate, or may include other materials such as silicon-germanium (SiGe), SiGe-on-insulator (SGOI), indium antimonide, lead telluride compounds, indium arsenide, indium phosphide, gallium arsenide, or gallium antimonide, but the present disclosure is not limited thereto. For convenience, the substrate 100 will hereinafter be described as being as a Si substrate.

The first interlayer insulating film 201 may be disposed on the substrate 100. The first interlayer insulating film 201 may include, for example, at least one of silicon oxide, silicon nitride, silicon oxynitride (SiON), silicon oxycarbonitride (SiOCN), or a combination thereof.

The storage contacts 120 may be disposed on the substrate 100. Specifically, the storage contacts 120 may be surrounded by the first interlayer insulating film 201 in plan view. The storage contacts 120 may include, for example, at least one of a doped semiconductor material, a conductive silicide compound, a conductive metal nitride, or a metal.

The landing pads LP may be disposed on the substrate 100. The landing pads LP may include, for example, at least one of a doped semiconductor material, a conductive silicide compound, a conductive metal nitride, or a metal. In the semiconductor memory device according to some embodiments, the landing pads LP may include tungsten (W).

The etch stop film 220 may be disposed on the first interlayer insulating film 201. The etch stop film 220 may expose at least parts of the landing pads LP. For example, the etch stop film 220 may be disposed on the landing ads LP. The etch stop film 220 may include bottom electrode holes that expose at least parts of the landing pads LP.

The etch stop film 220 may include, for example, at least one of silicon nitride (SiN), silicon carbonitride (SiCN), silicon boron nitride (SiBN), silicon oxycarbide (SiCO), SiON, silicon oxide (SiO), or silicon oxycarbonitride (SiOCN). Here, the expression "silicon oxycarbide (SiCO)," for example, implies the inclusion of Si, carbon (C), and oxygen (O), not necessarily indicating the ratio among them.

The data storage pattern DSP may be disposed on the landing pads LP. The data storage pattern DSP may include lower electrodes 301, a capacitor dielectric film structure 400, and an upper electrode 302.

The lower electrodes 301 may be disposed on the landing pads LP. The lower electrodes 301 may be connected to the landing pads LP.

The lower electrodes 301 may extend longitudinally in a second direction DR2. The length by which the lower electrodes 301 extend in the second direction DR2 is greater than the length by which the lower electrodes 301 extend in a first direction DR1. That is, the length by which the lower electrodes 301 extend in the second direction DR2 may be greater than the width, in the first direction DR1, of the lower electrodes 301. For example, the lower electrodes 301 may have a pillar shape.

Here, the second direction DR2 may refer to a direction parallel to the thickness direction of the substrate 100. The first direction DR1 may refer to a direction that crosses the second direction DR2 and is parallel to the upper surface of the substrate 100 or the first interlayer insulating film 201.

Parts of the lower electrodes 301 may be disposed within the etch stop film 220. The lower electrodes 301 may be connected to the landing pads LP through the etch stop film 220. For example, parts of the sidewalls of the lower electrodes 301 may be in contact with the etch stop film 220.

The lower electrodes 301 may include, for example, a doped semiconductor material, a conductive metal nitride (e.g., titanium nitride, tantalum nitride, niobium nitride, or tungsten nitride), a metal (e.g., ruthenium, iridium, titanium, or tantalum), or a conductive metal oxide (e.g., iridium oxide or niobium oxide), but the present disclosure is not limited thereto. In the semiconductor memory device according to some embodiments, the lower electrodes 301 may include titanium nitride (TiN). Additionally, in the semiconductor memory device according to some embodiments, the lower electrodes 301 may include niobium nitride (NbN).

The lower support pattern 141 may be disposed on the etch stop film 220. The lower support pattern 141 may be spaced apart from the etch stop film 220 in the second direction DR2. The lower support pattern 141 may be in contact with the lower electrodes 301. The lower support pattern 141 may be in contact with parts of the sidewalls of the lower electrodes 301.

The lower support pattern 141 may electrically or physically connect the lower electrodes 301 that are adjacent to each other in the first direction DR1. FIG. 1 illustrates that two lower electrodes 301 are connected by the lower support pattern 141, but the present disclosure is not limited thereto.

The upper support pattern 142 may be disposed on the lower support pattern 141. The upper support pattern 142 may be spaced apart from the lower support pattern 141 in the second direction DR2. The upper support pattern 142 may be in contact with the lower electrodes 301. The upper support pattern 142 may be in contact with parts of the sidewalls of the lower electrodes 301.

The upper support pattern 142 may connect the lower electrodes 301 that are adjacent to each other in the first direction DR1. FIG. 1 illustrates that two lower electrodes 301 are connected by the upper support pattern 142, but the present disclosure is not limited thereto.

For example, as illustrated, the upper surface of the upper support pattern 142 may be on the same plane as the upper surfaces of the lower electrodes 301. In some embodiments, the upper surface of the lower electrodes 301 may protrude in a direction D2 away from the substrate 100. For convenience, the upper surface of the upper support pattern 142 will hereinafter be described as being on the same plane as the upper surfaces of the lower electrodes 301.

The lower and upper support patterns 141 and 142 may each include, for example, at least one of SiN, SiCN, SiBN, SiCO, SiON, SiO, or SiOCN. In the semiconductor memory device according to some embodiments, the lower and upper support patterns 141 and 142 may each include SiCN or SiN.

The capacitor dielectric film structure 400 may be in the form of a thin film covering the lower electrodes 301, the etch stop film 220, and the upper support pattern 142. In other words, the capacitor dielectric film structure 400 may be disposed between the upper electrode 302 and the lower electrodes 301.

The capacitor dielectric film structure 400 may include, for example, one of silicon oxide, silicon nitride, silicon oxynitride, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, or a combination thereof, but the present disclosure is not limited thereto. In FIG. 1, the capacitor dielectric film structure 400 is illustrated as being a single film, but the present disclosure is not limited thereto.

In the semiconductor memory device according to some embodiments, the capacitor dielectric film structure 400 may have a stacked film structure in which a first ferroelectric material film 401, a first insertion film 901, a second ferroelectric material film 402, and a paraelectric material film 501 are sequentially stacked.

The first ferroelectric material film 401 may be disposed closer than the paraelectric material film 501 to the lower electrodes 301. The first ferroelectric material film 401 may have ferroelectric properties. The first ferroelectric material film 401 may have a sufficient thickness to exhibit ferroelectric properties. The thickness of the first ferroelectric material film 401 with ferroelectric properties may vary depending on the ferroelectric material used.

For example, the first ferroelectric material film 401 may include a monometal oxide. The first ferroelectric material film 401 may contain crystals with an orthorhombic crystal structure. In some embodiments, the first ferroelectric material film 401 may include a multiple film or a laminate film.

For example, the first ferroelectric material film 401 may include at least one of zirconium (Zr), hafnium (Hf), or titanium (Ti). For example, if the first ferroelectric material film 401 includes a metal oxide such as hafnium zirconium oxide (HfZrOₓ), the first ferroelectric material film 401 may have a stoichiometric or non-stoichiometric chemical formula. The dielectric constant (K) of the material of the first ferroelectric material film 401 is greater than that of the material of the paraelectric material film 501.

The first insertion film 901 may be disposed on the first ferroelectric material film 401. Specifically, the first insertion film 901 may be disposed between the first and second ferroelectric material films 401 and 402. The first insertion film 901 may be in direct contact with the first and second ferroelectric material films 401 and 402.

The first insertion film 901 may include an oxide of at least one of Zr, Ti, tantalum (Ta), niobium (Nb), lanthanum (La), barium (Ba), and vanadium (V), but the present disclosure is not limited thereto. The first insertion film 901 may be a single film, but the present disclosure is not limited thereto. In some embodiments, the first insertion film 901 may include a multifilm or a laminate film.

The dielectric constant of the material of the first insertion film 901 is greater than that of the materials of the first ferroelectric material film 401, the second ferroelectric material film 402, and the paraelectric material film 501.

The second ferroelectric material film 402 may have ferroelectric properties. The second ferroelectric material film 402 may have a thickness sufficient to exhibit ferroelectric properties. The thickness of the second ferroelectric material film 402 that exhibits ferroelectric properties may vary depending on the ferroelectric material used.

For example, the second ferroelectric material film 402 may include a monometal oxide. The second ferroelectric material film 402 may contain crystals with an orthorhombic crystal structure. In some embodiments, the second ferroelectric material film 402 may include a multifilm or a laminate film.

For example, the second ferroelectric material film 402 may include at least one of Zr, Hf, or Ti. If the second ferroelectric material film 402 includes a metal oxide such as HfZrOₓ, the second ferroelectric material film 402 may have a stoichiometric or non-stoichiometric chemical formula. The dielectric constant of the material of the second ferroelectric material film 402 is greater than that of the material of the paraelectric material film 501.

The first ferroelectric material film 401 may have a thickness L1 in a fourth direction DR4. The second ferroelectric material film 402 may have a thickness L2 in the fourth direction DR4. The paraelectric material film 501 may have a thickness K in the fourth direction DR4. The first insertion film 901 may have a thickness D in the fourth direction DR4.

The sum of the thicknesses L1, D, and L2, in the fourth direction DR4, of the first ferroelectric material film 401, the first insertion film 901, and the second ferroelectric material film 402 may be less than about 60% of a thickness M, in the fourth direction DR4, of the capacitor dielectric film structure 400. In other words, the thickness K, in the fourth direction DR4, of the paraelectric material film 501 may be at least about 40% of the thickness M, in the fourth direction DR4, of the capacitor dielectric film structure 400.

When the sum of the thicknesses L1, D, and L2, in the fourth direction DR4, of the first ferroelectric material film 401, the first insertion film 901, and the second ferroelectric material film 402 is less than about 60% of the thickness M, in the fourth direction DR4, of the capacitor dielectric film structure 400, the characteristics of the volatile semiconductor memory device can be maintained.

The thickness D, in the fourth direction DR4, of the first insertion film 901 may be about 5% to about 30% of the sum of the thicknesses L1 and L2, in the fourth direction DR4, of the first and second ferroelectric material films 401 and 402. When the thickness D, in the fourth direction DR4, of the first insertion film 901 is between about 5% and about 30% of the sum of the thicknesses L1 and L2, in the fourth direction DR4, of the first and second ferroelectric material films 401 and 402, the first and second ferroelectric material films 401 and 402 can easily have an orthorhombic crystal structure.

The paraelectric material film 501 may have paraelectric properties. For example, the paraelectric material film 501 may include a monometal oxide. The paraelectric material film 501 may contain a metal oxide film. Here, the metal oxide may be a binary compound composed of one metal and oxygen. The paraelectric material film 501 containing a metal oxide may have at least one of a monoclinic crystal system and a tetragonal crystal system. In some embodiments, the paraelectric material film 501 may include a multifilm or a laminate film.

For example, the paraelectric material film 501 may include at least one of Zr, Hf, or Ti. For example, if the paraelectric material film 501 includes a metal oxide such as HfZrOₓ, the paraelectric material film 501 may have a stoichiometric or non-stoichiometric chemical formula. The dielectric constant of the material of the paraelectric material film 501 is less than that of the materials of the first ferroelectric material film 401, the first insertion film 901, and the second ferroelectric material film 402.

The upper electrode 302 may be disposed on the capacitor dielectric film structure 400. The upper electrode 302 may extend along the profile of the capacitor dielectric film structure 400.

The upper electrode 302 may include, for example, a doped semiconductor material, a conductive metal nitrides (e.g., titanium nitride, tantalum nitride, niobium nitride, or tungsten nitride), a metal (e.g., ruthenium, iridium, titanium, or tantalum), or a conductive metal oxide (e.g., iridium oxide or niobium oxide), but the present disclosure is not limited thereto. Also, in the semiconductor memory device according to some embodiments, the upper electrode 302 may include titanium nitride (TiN). Additionally, in the semiconductor memory device according to some embodiments, the upper electrode 302 may include niobium nitride (NbN).

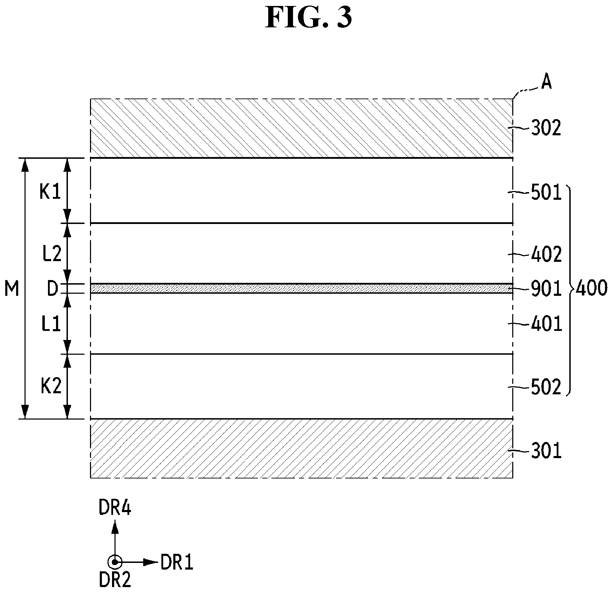

FIG. 3 is a cross-sectional view illustrating a semiconductor memory device according to some embodiments. For convenience, the embodiment of FIG. 3 will hereinafter be described, focusing mainly on the differences from what has been described with reference to FIGS. 1 and 2.

Referring to FIG. 3, the semiconductor memory device according to some embodiments may further include a second paraelectric material film 502, which is disposed between lower electrodes 301 and a first ferroelectric material film 401.

The second paraelectric material film 502 may have paraelectric properties. For example, the second paraelectric material film 502 may include a monometal oxide. The second paraelectric material film 502 may contain a metal oxide film. Here, the metal oxide may be a binary compound composed of one metal and oxygen. The second paraelectric material film 502 containing a metal oxide may have at least one of a monoclinic crystal system and a tetragonal crystal system. In some embodiments, the second paraelectric material film 502 may include a multifilm or a laminate film.

For example, the second paraelectric material film 502 may include at least one of Zr, Hf, or Ti. For example, if the second paraelectric material film 502 includes a metal oxide such as HfZrOₓ, the second paraelectric material film 502 may have a stoichiometric or non-stoichiometric chemical formula. The dielectric constant of the material of the second paraelectric material film 502 is less than that of the materials of the first ferroelectric material film 401, a first insertion film 901, and a second ferroelectric material film 402.

A first paraelectric material film 501 may have a thickness K1 in a fourth direction DR4. The second paraelectric material film 502 may have a thickness K2 in the fourth direction DR4. The first insertion film 901 may have a thickness D in the fourth direction DR4.

The sum of a thickness L1, in the fourth direction DR4, of the first ferroelectric material film 401, the thickness D, in the fourth direction DR4, of the first insertion film 901, and a thickness L2, in the fourth direction DR4, of the second ferroelectric material film 402 may be less than about 60% of a thickness M, in the fourth direction DR4, of a capacitor dielectric film structure 400. In other words, the sum of the thicknesses K1 and K2, in the fourth direction DR4, of the first and second paraelectric material films 501 and 502 may be at least about 40% of the thickness M, in the fourth direction DR4, of the capacitor dielectric film structure 400. If the sum of the thicknesses L1, D, and L2, in the fourth direction DR4, of the first ferroelectric material film 401, the first insertion film 901, and the second ferroelectric material film 402 is less than about 60% of the thickness M, in the fourth direction DR4, of the capacitor dielectric film structure 400, the characteristics of the volatile semiconductor memory device can be maintained.

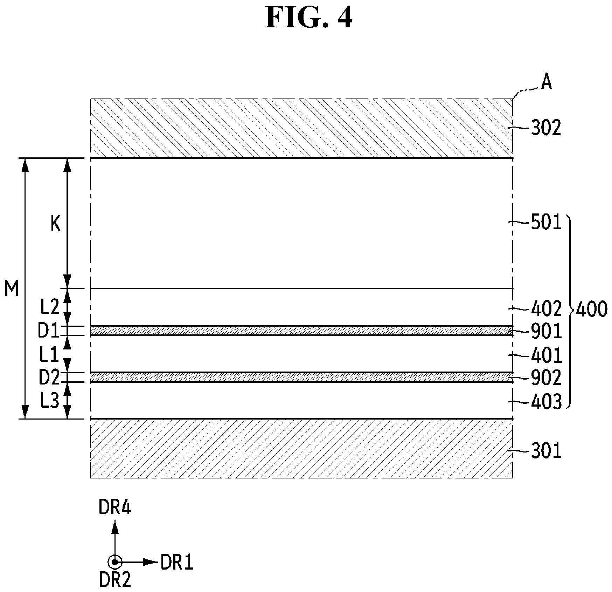

FIG. 4 is a cross-sectional view illustrating a semiconductor memory device according to some embodiments. For convenience, the embodiment of FIG. 4 will hereinafter be described, focusing mainly on the differences from what has been described with reference to FIGS. 1 and 2.

Referring to FIG. 4, the semiconductor memory device according to some embodiments may further include a third ferroelectric material film 403 and a second insertion film 902, which are sequentially arranged between lower electrodes 301 and a first ferroelectric material film 401.

The third ferroelectric material film 403 may be disposed closer than the second insertion film 902 to the lower electrodes 301. In other words, the second insertion film 902 may be disposed between the first ferroelectric material film 401 and the third ferroelectric material film 403.

The third ferroelectric material film 403 may have ferroelectric properties. The third ferroelectric material film 403 may have a thickness sufficient to exhibit ferroelectric properties. The thickness of the third ferroelectric material film 403 that exhibits ferroelectric properties may vary depending on the ferroelectric material used.

For example, the third ferroelectric material film 403 may include a monometal oxide. The third ferroelectric material film 403 may contain a metal oxide film. Here, the metal oxide may be a binary compound composed of one metal and oxygen. The third ferroelectric material film 403 containing a metal oxide may include crystals with an orthorhombic crystal structure. In some embodiments, the third ferroelectric material film 403 may include a multifilm or a laminate film.

For example, the third ferroelectric material film 403 may include at least one of Zr, Hf, or Ti. If the third ferroelectric material film 403 includes a metal oxide such as HfZrOₓ, the third ferroelectric material film 403 may have a stoichiometric or non-stoichiometric chemical formula. The dielectric constant of the material of the third ferroelectric material film 403 is greater than that of the material of a paraelectric material film 501.

The second insertion film 902 may be disposed on the third ferroelectric material film 403. Specifically, the second insertion film 902 may directly contact the first and third ferroelectric material films 401 and 403.

The second insertion film 902 may include an oxide of at least one of Zr, Ti, Ta, Nb, La, Ba, or V. The second insertion film 902 may be a single film, but the present disclosure is not limited thereto. In some embodiments, the second insertion film 902 may include a multifilm or a laminate film.

The dielectric constant of the material of the second insertion film 902 is greater than that of the materials of the first ferroelectric material film 401, a second ferroelectric material film 402, and the paraelectric material film 501.

The third ferroelectric material film 403 may have a thickness L3 in a fourth direction DR4. The paraelectric material film 501 may have a thickness K in the fourth direction DR4. A first insertion film 901 may have a thickness D1 in the fourth direction DR4. The second insertion film 902 may have a thickness D2 in the fourth direction DR4.

The sum of the thickness L3, in the fourth direction DR4, of the third ferroelectric material film 403, the thickness D1, in the fourth direction DR4, of the first insertion film 901, a thickness L 1, in the fourth direction DR4, of the first ferroelectric material film 401, the thickness D2, in the fourth direction DR4, of the second insertion film 902, and a thickness L2, in the fourth direction DR4, of the second ferroelectric material film 402 may be less than about 60% of a thickness M, in the fourth direction DR4, of a capacitor dielectric film structure 400. In other words, the thickness K, in the fourth direction DR4, of the paraelectric material film 501 may be at least about 40% of the thickness M, in the fourth direction DR4, of the capacitor dielectric film structure 400.

If the sum of the thicknesses L3, D1, L1, D2, and L2, in the fourth direction DR4, of the third ferroelectric material film 403, the first insertion film 901, the first ferroelectric material film 401, the second insertion film 902, and the second ferroelectric material film 402 is less than about 60% of the thickness M, in the fourth direction DR4, of the capacitor dielectric film structure 400, the characteristics of the volatile semiconductor memory device can be maintained.

The sum of the thicknesses D1 and D2, in the fourth direction DR4, of the first and second insertion films 901 and 902 may be about 5% to about 30% of the sum of the thicknesses L1, L2, and L3, in the fourth direction DR4, of the first, second, and third ferroelectric material films 401, 402, and 403. If the sum of the thicknesses D1 and D2, in the fourth direction DR4, of the first and second insertion films 901 and 902 is between about 5% and about 30% of the sum of the thicknesses L1, L2, and L3, in the fourth direction DR4, of the first, second, and third ferroelectric material films 401, 402, and 403, the first, second, and third ferroelectric material films 401, 402, and 403 can easily have an orthorhombic crystal structure.

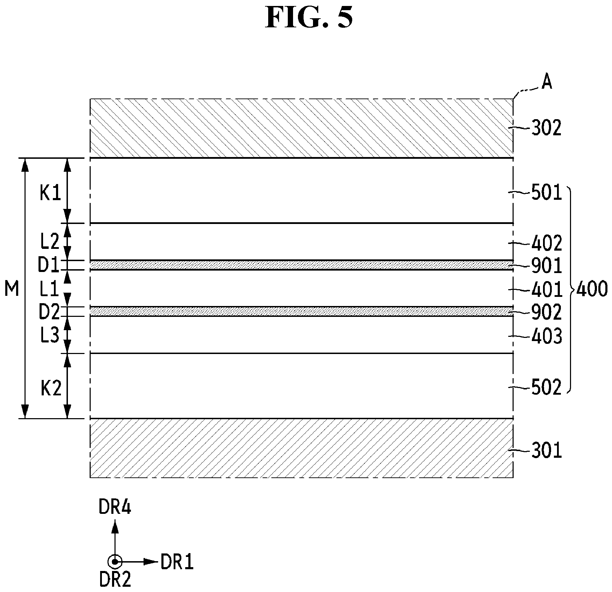

FIG. 5 is a cross-sectional view illustrating a semiconductor memory device according to some embodiments. For convenience, the embodiment of FIG. 5 will hereinafter be described, focusing mainly on the differences from what has been described with reference to FIGS. 1 and 4.

Referring to FIG. 5, the semiconductor memory device according to some embodiments may further include a second paraelectric material film 502, which is disposed between lower electrodes 301 and a third ferroelectric material film 403.

The second paraelectric material film 502 may have paraelectric properties. For example, the second paraelectric material film 502 may include a monometal oxide. The second paraelectric material film 502 may contain a metal oxide film. Here, the metal oxide may be a binary compound composed of one metal and oxygen. The second paraelectric material film 502 containing a metal oxide may have at least one of a monoclinic crystal system and a tetragonal crystal system. In some embodiments, the second paraelectric material film 502 may include a multifilm or a laminate film.

For example, the second paraelectric material film 502 may include at least one of Zr, Hf, or Ti. For example, if the second paraelectric material film 502 includes a metal oxide such as HfZrOₓ, the second paraelectric material film 502 may have a stoichiometric or non-stoichiometric chemical formula. The dielectric constant of the material of the second paraelectric material film 502 is less than that of the materials of a first ferroelectric material film 401, a first insertion film 901, and a second ferroelectric material film 402.

A first paraelectric material film 501 may have a thickness K1 in a fourth direction DR4. The second paraelectric material film 502 may have a thickness K2 in the fourth direction DR4. The first insertion film 901 may have a thickness D1 in the fourth direction DR4. A second insertion film 902 may have a thickness D2 in the fourth direction DR4.

The sum of a thickness L3, in the fourth direction DR4, of a third ferroelectric material film 403, the thickness D1, in the fourth direction DR4, of the first insertion film 901, a thickness L 1, in the fourth direction DR4, of the first ferroelectric material film 401, the thickness D2, in the fourth direction DR4, of the second insertion film 902, and a thickness L2, in the fourth direction DR4, of the second ferroelectric material film 402 may be less than about 60% of a thickness M, in the fourth direction DR4, of a capacitor dielectric film structure 400. In other words, the sum of the thicknesses K1 and K2, in the fourth direction DR4, of the first and second paraelectric material films 501 and 502 may be at least about 40% of the thickness M, in the fourth direction DR4, of the capacitor dielectric film structure 400.

If the sum of the thicknesses L3, D1, L1, D2, and L2, in the fourth direction DR4, of the third ferroelectric material film 403, the first insertion film 901, the first ferroelectric material film 401, the second insertion film 902, and the second ferroelectric material film 402 is less than about 60% of the thickness M, in the fourth direction DR4, of the capacitor dielectric film structure 400, the characteristics of the volatile semiconductor memory device can be maintained.

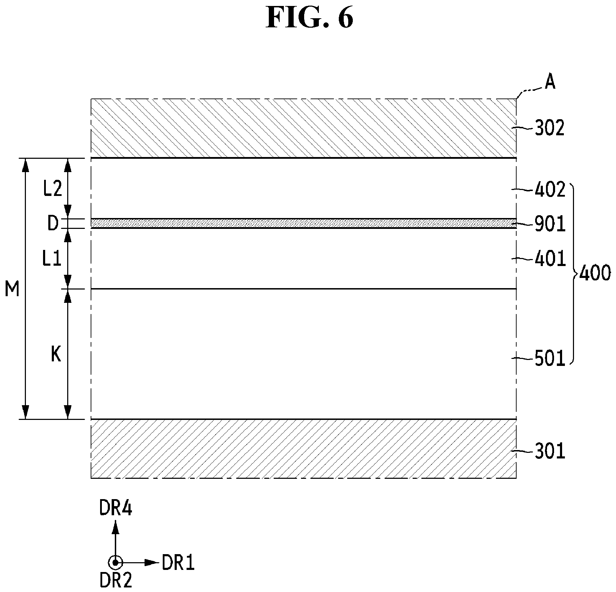

FIG. 6 is a cross-sectional view illustrating a semiconductor memory device according to some embodiments. For convenience, the embodiment of FIG. 6 will hereinafter be described, focusing mainly on the differences from what has been described with reference to FIGS. 1 and 2.

Referring to FIG. 6, the semiconductor memory device according to some embodiments may have a stacked film structure in which a paraelectric material film 501, a first ferroelectric material film 401, a first insertion film 901, and a second ferroelectric material film 402 are sequentially stacked.

The first ferroelectric material film 401 may be disposed closer than a paraelectric material film 501 to an upper electrode 302.

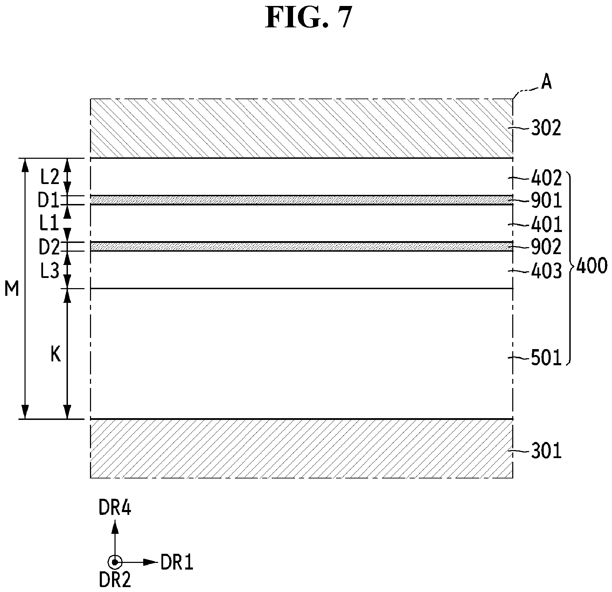

FIG. 7 is a cross-sectional view illustrating a semiconductor memory device according to some embodiments. For convenience, the embodiment of FIG. 7 will hereinafter be described, focusing mainly on the differences from what has been described with reference to FIGS. 1 and 4.

Referring to FIG. 7, a third ferroelectric material film 403 may be disposed closer than a paraelectric material film 501 to an upper electrode 302. In other words, the paraelectric material film 501 may directly contact lower electrodes 301.

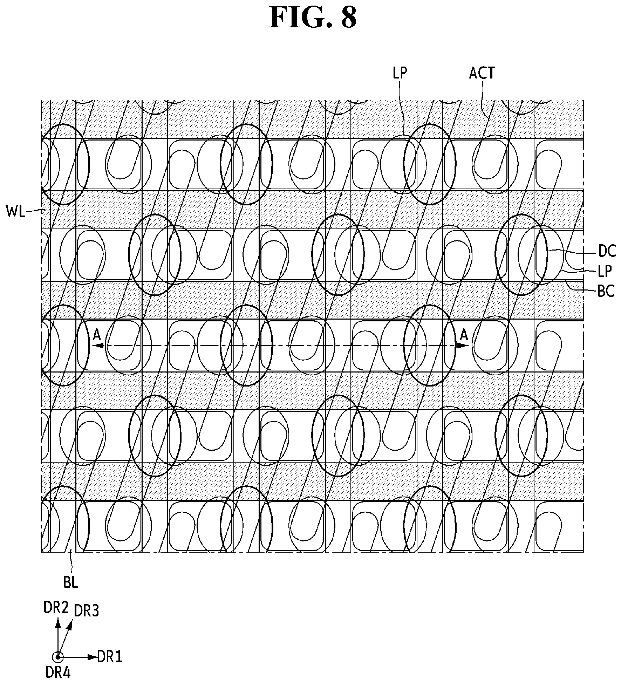

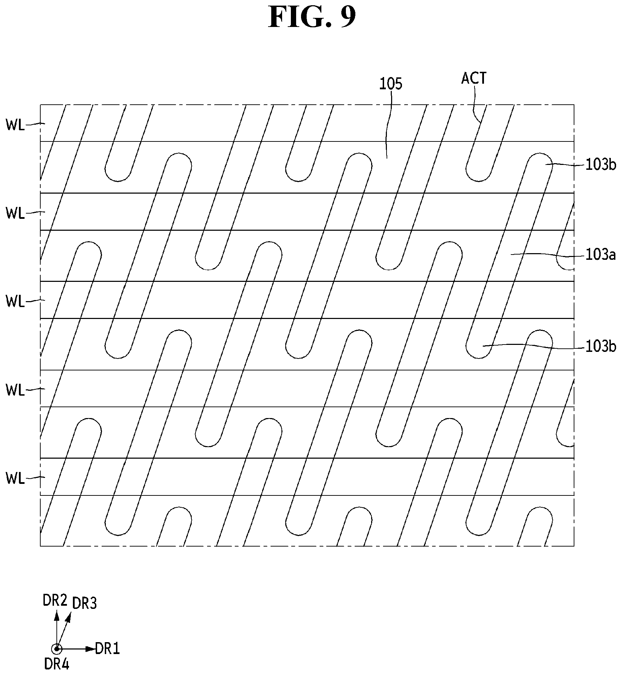

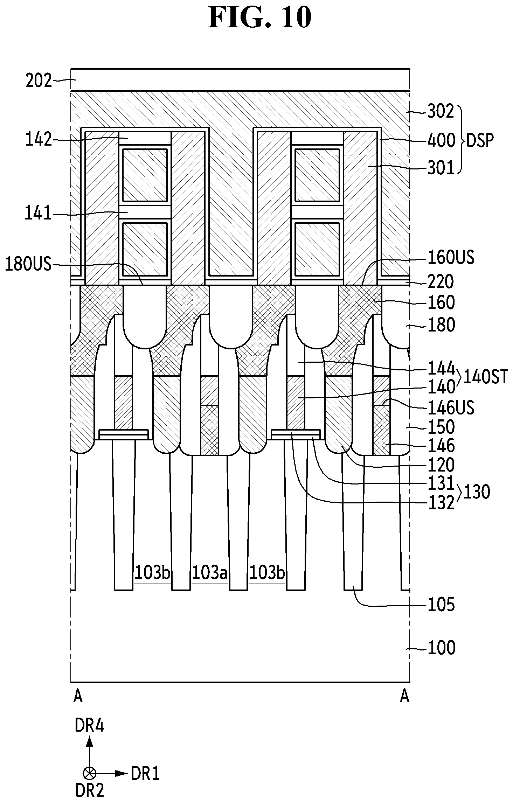

FIG. 8 is a layout view of a semiconductor memory device according to other embodiments. FIG. 9 is a layout view illustrating wordlines and a cell active area film of FIG. 8. FIG. 10 is a cross-sectional view taken along A - A of FIG. 8.

Specifically, FIG. 8 illustrates an example layout view of a Dynamic Random-Access Memory (DRAM) excluding a data storage pattern DSP, but the present disclosure is not limited thereto.

Referring to FIG. 8, first and second directions DR1 and DR2 may correspond to their respective counterparts of FIG. 1, but the present disclosure is not limited thereto. In some embodiments, the first direction DR1 may correspond to the second direction DR2 of FIG. 1, and the second direction DR2 may correspond to the first direction DR1 of FIG. 1.

Referring to FIGS. 8 through 10, the semiconductor memory device according to some embodiments may include a plurality of cell active areas ACT.

The cell active areas ACT may be defined by a cell isolation film 105, which is formed within a substrate 100. As illustrated, due to the decrease in the design rules for the semiconductor memory device according to some embodiments, the cell active areas ACT may be arranged in the form of diagonal or oblique bars. For example, the cell active areas ACT may extend in a third direction DR3.

A plurality of gate electrodes, which extend in the first direction DR1 across the cell active areas ACT, may be arranged. The gate electrodes may extend in parallel to one another. The gate electrodes may be, for example, wordlines WL. The wordlines WL may be arranged at regular intervals. The width of or the spacing between the wordlines WL may be determined according to the design rules.

Each of the cell active areas ACT may be divided into three sections by two wordlines WL extending in the first direction DR1. Each of the cell active areas ACT may include storage connection areas 103b and a bitline connection area 103a. The bitline connection areas 103a may be disposed in the middle of the respective cell active areas ACT, and the storage connection areas 103b may be disposed at the ends of the respective cell active areas ACT.

For example, the bitline connection areas 103a may be areas connected to bitlines BL, and the storage connection areas 103b may be areas connected to a data storage pattern DSP. In other words, the bitline connection areas 103a may correspond to common drain areas, and the storage connection areas 103b may correspond to source areas. Each of the wordlines WL, and pairs of bitline connection areas 103a and storage connection areas 103b that are both adjacent to the corresponding wordline WL may form transistors.

On the wordlines WL, the bitlines BL, which extend in the second direction DR2 orthogonally to the wordlines WL, may be arranged. The bitlines BL may extend in parallel to one another. The bitlines BL may be arranged at regular intervals. The width of or spacing between the bitlines BL may be determined according to the design rules.

A fourth direction DR4 may be orthogonal to the first, second, and third directions DR1, DR2, and DR3.

The semiconductor memory device according to some embodiments may include various contact arrays formed on the cell active areas ACT. These various contact arrays may include, for example, direct contacts DC, buried contacts BC, and landing pads LP.

Here, the direct contacts DC may refer to contacts that electrically connect the cell active areas ACT to the bitlines BL, and the buried contacts BC may refer to contacts that connect the cell active areas ACT to lower electrodes 301 of the data storage pattern DSP.

In terms of layout, the contact area between the buried contacts BC and the cell active areas ACT may be small. Accordingly, conductive landing pads LP may be introduced to expand the contact area with the cell active areas ACT and increase the contact area with the lower electrodes 301 of the data storage pattern DSP.

In the semiconductor memory device according to some embodiments, the landing pads LP may be disposed between the buried contacts BC and the lower electrodes 301 of the data storage pattern DSP. The introduction of landing pads LP can increase the contact area, thereby reducing the contact resistance between the cell active areas ACT and the lower electrodes 301 of the data storage pattern DSP.

In the semiconductor memory device according to some embodiments, the direct contacts DC may be disposed in the middle of the cell active areas ACT. The buried contacts BC may be disposed at the ends of the cell active areas ACT. The direct contacts DC may be connected to the bitline connection areas 103a. The buried contacts BC may be connected to the storage connection areas 103b.

As the buried contacts BC are disposed at the ends of the cell active areas ACT, the landing pads LP may be disposed adjacent to the ends of the cell active areas ACT, partially overlapping with the buried contacts BC. In some embodiments, the buried contacts BC may be formed to overlap with the cell active areas ACT and parts of the cell isolation film 105 between the wordlines WL and between the bitlines BL.

The wordlines WL may be formed to be buried within the substrate. The wordlines WL may be arranged across the cell active areas ACT between the direct contacts DC or between the buried contacts BC.

As illustrated, two wordlines WL may be arranged to traverse a single cell active area ACT. As the cell active areas ACT are arranged diagonally, the wordlines WL may form an angle of less than 90 degrees with the cell active areas ACT.

The direct contacts DC and the buried contacts BC may be symmetrically arranged. As a result, the direct contacts DC and the buried contacts BC may be arranged in straight lines along the first and second directions DR1 and DR2.

Unlike the direct contacts DC and the buried contacts BC, the landing pads LP may be arranged in a zigzag pattern along the second direction DR2, which is the extension direction of the bitlines BL. Additionally, the landing pads LP may be disposed to overlap with the same sides of each of the bitlines BL along the first direction DR1, which is the extension direction of the wordlines WL.

For example, a first line of landing pads LP may overlap with the left side of a corresponding bitline BL, and a second line of landing pads LP may overlap with the right side of the corresponding bitline BL.

The semiconductor memory device according to some embodiments may include a plurality of bitline structures 140ST, a plurality of storage contacts 120, a plurality of bitline contacts 146, and the data storage pattern DSP.

The cell isolation film 105 may be disposed within the substrate 100. The cell isolation film 105 may have a shallow trench isolation (STI) structure with excellent device isolation characteristics. The cell isolation film 105 may define the cell active areas ACT within a memory cell area.

The cell active areas ACT defined by the cell isolation film 105 may be formed as elongated islands that include both short and long axes, as illustrated in FIGS. 8 and 9. The cell active areas ACT may be arranged diagonally, forming an angle of less than 90 degrees relative to the wordlines WL formed within the cell isolation film 105. Additionally, the cell active areas ACT may be arranged diagonally to form an angle of less than 90 degrees relative to the bitlines BL, which are formed on the cell isolation film 105.

The cell isolation film 105 may include, for example, at least one of silicon oxide, silicon nitride, and silicon oxynitride, but the present disclosure is not limited thereto.

The cell isolation film 105 is illustrated as being a single insulating film, but the present disclosure is not limited thereto. Depending on the spacing between the cell active areas ACT, the cell isolation film 105 may be formed as a single insulating layer or multiple insulating films.

The bitline structures 140ST may include cell conductive lines 140, a cell line capping film 144, and bitline spacers 150.

The cell conductive lines 140 may be disposed on the substrate 100 and the cell isolation film 105 where the word lines WL are formed. The cell conductive lines 140 may intersect the cell isolation film 105 and the cell active areas ACT defined by the cell isolation film 105. The cell conductive lines 140 may be formed to intersect the wordlines WL. Here, the cell conductive lines 140 may correspond to the bitlines BL. For example, the cell conductive lines 140 may be the bitlines BL of FIG. 8.

The cell conductive lines 140 may include, for example, at least one of an impurity-doped semiconductor material, a conductive silicide compound, a conductive metal nitride, a 2D material, or a metal.

The cell conductive lines 140 are illustrated as being single films, but the present disclosure is not limited thereto. In some embodiments, contrary to what is depicted, the cell conductive lines 140 may include multiple conductive films with conductive materials stacked therein.

The cell line capping film 144 may be disposed on the cell conductive lines 140. The cell line capping film 144 may extend along the upper surfaces of the cell conductive lines 140 in the second direction DR2. The cell line capping film 144 may include, for example, at least one of silicon nitride, SiON, SiCN, or SiOCN.

In the semiconductor memory device according to some embodiments, the cell line capping film 144 may include silicon nitride. The cell line capping film 144 is illustrated as being a single film, but the present disclosure is not limited thereto.

The bitline spacers 150 may be disposed on the sidewalls of the cell conductive lines 140 and the cell line capping film 144. The bitline spacers 150 extends longitudinally in the second direction DR2.

The bitline spacers 150 are illustrated as being single films, but the present disclosure is not limited thereto. In some embodiments, contrary to what is depicted, the bitline spacers 150 may have a multifilm structure. The bitline spacers 150 may include, for example, one of silicon oxide, silicon nitride, silicon oxynitride, silicon oxycarbonitride, air, or a combination thereof, but the present disclosure is not limited thereto.

The cell insulating film 130 may be disposed on the substrate 100 and the cell isolation film 105. Specifically, the cell insulating film 130 may be disposed on the upper surfaces of the substrate 100 and the cell isolation film 105 where the bitline contacts 146 and the storage contacts 120 are not formed. The cell insulating film 130 may be formed between the substrate 100 and the cell conductive lines 140, and between the cell isolation film 105 and the cell conductive lines 140.

The cell insulating film 130 may be a single film. In some embodiments, as illustrated, the cell insulating film 130 may be a multifilm including a first cell insulating film 131 and a second cell insulating film 132. For example, the first cell insulating film 131 and the second cell insulating film 132 may include a silicon oxide film and a silicon nitride film, respectively, but the present disclosure is not limited thereto. In some embodiments, contrary to what is depicted, the cell insulating film 130 may be a triple film including a silicon oxide film, a silicon nitride film, and another silicon oxide film, but the present disclosure is not limited thereto.

The bitline contacts 146 may be disposed between the cell conductive lines 140 and the substrate 100. The cell conductive lines 140 may be disposed on the bitline contacts 146.

The bitline contacts 146 may be disposed between the bitline connection areas 103a of the cell active areas ACT and the cell conductive lines 140. The bitline contacts 146 may electrically connect the cell conductive lines 140 and the substrate 100. The bitline contacts 146 may be connected to the bitline connection areas 103a.

The bitline contacts 146 may include upper surfaces 146US, which are connected to the cell conductive lines 140. The width, in the first direction DR1, of the bitline contacts 146 is illustrated as being uniform away from the upper surfaces 146US, but the present disclosure is not limited thereto.

The bitline contacts 146 may correspond to the direct contacts DC. The bitline contacts 146 may include, for example, at least one of an impurity-doped semiconductor material, a conductive metal silicide, a conductive metal nitride, a conductive metal oxide, a metal, or a metal alloy.

In cell conductive lines 140 where the bitline spacers 150 are formed, the bitline spacers 150 may be disposed on the substrate 100 and the cell isolation film 105. The bitline spacers 150 may be disposed on the sidewalls of the cell conductive lines 140, the cell line capping film 144, and the bitline contacts 146.

In cell conductive lines 140 where the bitline contacts 146 are not formed, the bitline spacers 150 may be disposed on the cell insulating film 130. The bitline spacers 150 may be disposed on the sidewalls of the cell conductive lines 140 and the cell line capping film 144.

The storage contacts 120 may be disposed between cell conductive lines 140 that are adjacent to one another in the first direction DR1. The storage contacts 120 may be disposed on both sides of the cell conductive lines 140. Specifically, the storage contacts 120 may be disposed between the bitline structures 140ST. The storage contacts 120 may be disposed between wordlines WL that are adjacent to one another in the second direction DR2.

The storage contacts 120 may overlap with the substrate 100 and the cell isolation film 105 between neighboring cell conductive lines 140. The storage contacts 120 may be connected to the cell active areas ACT. Specifically, the storage contacts 120 may be connected to the storage connection areas 103b. Here, the storage contacts 120 may correspond to the buried contacts BC of FIG. 8.

The storage contacts 120 may include, for example, at least one of an impurity-doped semiconductor material, a conductive silicide compound, a conductive metal nitride, a conductive metal carbide, a conductive metal carbonitride, a conductive metal oxide, or a metal.

Storage pads 160 may be disposed on the storage contacts 120. The storage pads 160 may be electrically connected to the storage contacts 120. The storage pads 160 may be connected to the storage connection areas 103b of the cell active areas ACT. Here, the storage pads 160 may correspond to the landing pads LP of FIG. 8.

The storage pads 160 may overlap with parts of the upper surfaces of the bitline structures 140ST. For example, the storage pads 160 may include at least one of a conductive silicide compound, a conductive metal nitride, a conductive metal carbide, a conductive metal oxide, or a metal.

A pad separation insulating film 180 may be disposed on the storage pads 160 and the bitline structures 140ST. For example, the pad separation insulating film 180 may be disposed on the cell line capping film 144.

The pad separation insulating film 180 may define the storage pads 160, which form a plurality of isolated areas. The pad separation insulating film 180 may not cover or overlap upper surfaces 160US of the storage pads 160. For example, relative to the upper surface of the substrate 100, the height of the upper surfaces 160US of the storage pads 160 may be equal to the height of an upper surface 180US of the pad separation insulating film 180.

The pad separation insulating film 180 may include an insulating material and may electrically isolate the storage pads 160 from one another. For example, the pad separation insulating film 180 may include at least one of silicon oxide, silicon nitride, silicon oxynitride, silicon oxycarbonitride, or silicon carbonitride, but the present disclosure is not limited thereto.

A second etch stop film 195 may be disposed on the upper surfaces 160US of the storage pads 160 and the upper surface 180US of the pad separation insulating film 180. For example, the second etch stop film 195 may include, for example, at least one of SiN, SiCN, SiOCN, SiOC, or SiBN.

The data storage pattern DSP may be disposed on the storage pads 160. The data storage pattern DSP may be electrically connected to the storage pads 160. Portions of the data storage patterns DSP may be disposed within the second etch stop film 195.

The data storage pattern DSP may include, for example, capacitors. The data storage pattern DSP may include the lower electrodes 301, a capacitor dielectric film structure 400, and an upper electrode 302.

Lower support patterns 141 may support the lower electrodes 301. Upper support patterns 142 may support the upper electrode 302. The upper support patterns 142 may be disposed on the lower electrodes 301.

The lower electrodes 301, the capacitor dielectric film structure 400, and the upper electrode 302 may be substantially the same as their respective counterparts of FIGS. 1 through 7, and thus, further descriptions thereof will be omitted.

The lower support patterns 141 and the upper support patterns 142 may be substantially the same as their respective counterparts of FIGS. 1 through 7, and thus, further descriptions thereof will be omitted.

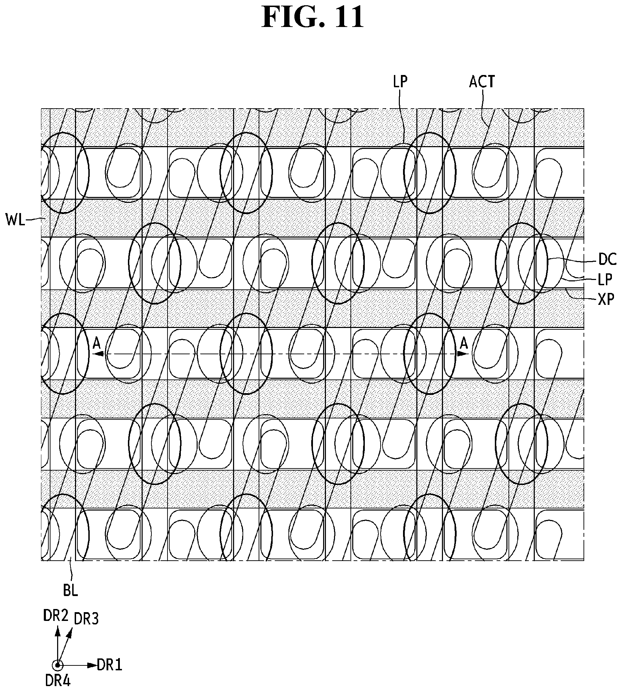

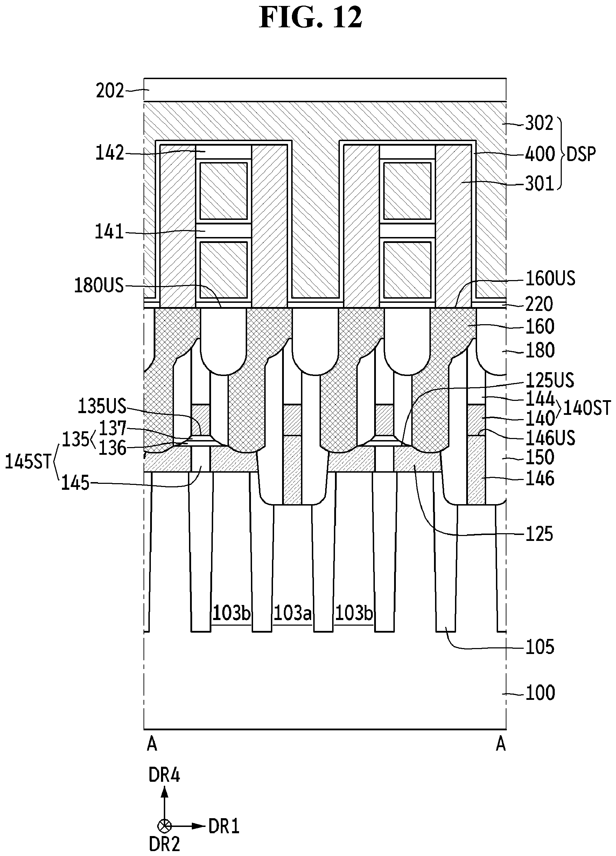

FIGS. 11 and 12 are diagrams illustrating a semiconductor memory device according to some embodiments. For convenience, the embodiment of FIGS. 11 and 12 will hereinafter be described, focusing mainly on the differences from what has been described with reference to FIGS. 8 through 10. Specifically, FIG. 12 is a cross-sectional view taken along line A-A of FIG. 11.

Referring to FIGS. 11 and 12, the semiconductor memory device according to some embodiments may include node pads XP, which are disposed on a substrate 100.

The node pads XP may be introduced instead of the buried contacts BC of FIG. 8. The node pads XP may be connection pads that connect cell active areas ACT to lower electrodes 301 of a data storage pattern DSP. The node pads XP may be connected to storage connection areas 103b.

In terms of layout, the contact area between the node pads XP and the cell active areas ACT may be small. Accordingly, conductive landing pads LP may be introduced to expand not only the contact area with the cell active areas ACT, but also the contact area with the lower electrodes 301 of the data storage pattern DSP.

As the node pads XP are disposed at the ends of the cell active areas ACT, landing pads LP may be disposed adjacent to the ends of the cell active areas ACT, partially overlapping with the node pads XP. In other words, the node pads XP may be formed to overlap with the cell active areas ACT and a cell isolation film 105, between neighboring wordlines WL and between neighboring bitlines BL.

The wordlines WL may be arranged across the cell active areas ACT between direct contacts DC or between the node pads XP. The direct contacts DC and the node pads XP may be symmetrically arranged. As a result, the direct contacts DC and the node pads XP may be arranged in straight lines along first and second directions DR1 and DR2 alignment in straight lines along the first and second directions DR1 and DR2.

Node connection pads 125 may be disposed on the substrate 100 and the cell isolation film 105. The lower surfaces of the node connection pads 125 may be disposed on the upper surface of the cell isolation film 105.

The lower surfaces of the node connection pads 125 may be disposed on the upper surface of the cell isolation film 105. The lower surfaces of the node connection pads 125 may be in contact with the upper surface of the cell isolation film 105. For example, the entire node connection pads 125 may be disposed on the upper surface of the substrate 100. Here, the node connection pads 125 may correspond to the node pads XP.

Relative to the upper surface of the cell isolation film 105, upper surfaces 125US of the node connection pads 125 may be lower than upper surfaces 146US of bitline contacts 146. Also, relative to the upper surface of the cell isolation film 105, the upper surfaces 125US of the node connection pads 125 may be lower than the lower surfaces of cell conductive lines 140.

Contact separation structures 145ST may be used to separate node connection pads 125 that are adjacent to one another in the first direction DR1. Although not illustrated, the contact separation structures 145ST may also separate node connection pads 125 that are adjacent to one another in the second direction DR2. The contact separation structures 145ST cover or overlap the upper surfaces 125US of the node connection pads 125.

The contact separation structures 145ST may include contact separation patterns 145 and an upper cell insulating film 135. The upper cell insulating film 135 may be disposed on the contact separation patterns 145.

When the node connection pads 125 include first node connection pads and second node connection pads that are spaced apart from the respective first node connection pads in the first direction DR1, the contact separation patterns 145 may separate the first node connection pads from the second node connection pads in the first direction DR1. Although not illustrated, the contact separation patterns 145 may also separate the node connection pads 125 that are adjacent in the second direction DR2.

The entire upper surfaces 125US of the node connection pads 125 may not contact the entire storage pads 160. In other words, the width, in the first direction DR1, of the interfaces between the node connection pads 121 and the storage pads 160 may be smaller than the width, in the first direction DR1, of the upper surfaces 125US of the node connection pads 125.

Bitline spacers 150 may be disposed on the upper surfaces 125US of the node connection pads 125.

The upper cell insulating film 135 covers, overlaps or is on the upper surfaces 125US of the node connection pads 125. When the node connection pads 125 include the first node connection pads and the second node connection pads, the upper cell insulating film 135 may cover, overlap, or be on both the upper surfaces of the first node connection pads and the upper surfaces of the second node connection pads.

The upper surface 135US of the upper cell insulating film 135 may be on the same plane as the upper surfaces 146US of the bitline contacts 146. That is, relative to the upper surface of the cell isolation film 105, the height of the upper surface 135US of the upper cell insulating film may be the same as the height of the upper surfaces 146US of the bitline contacts 146.

The cell conductive lines 140 may be disposed on the upper surfaces of the contact separation structures 145ST. The cell conductive lines 140 may be disposed on the upper surface 135US of the upper cell insulating film 135. The upper surfaces of the contact separation structures 145ST may correspond to the upper surface 135US of the upper cell insulating film 135. The upper surfaces of the contact separation structures 145ST may be on the same plane as the lower surfaces of the cell conductive lines 140.

The contact separation pattern 145 may include, for example, at least one of SiN, SiON, SiO₂, SiCN, SiOCN, or a combination thereof. The upper cell insulating film 135 may be a single film. In some embodiments, as illustrated, the upper cell insulating film 135 may be a multifilm consisting of a first upper cell insulating film 136 and a second upper cell insulating film 137. For example, the first upper cell insulating film 136 and the second upper cell insulating film 137 may include a silicon oxide film and a silicon nitride film, respectively, but the present disclosure is not limited thereto. The width, in the first direction DR1, of the upper cell insulating film 135 may decrease away from the substrate 100, but the present disclosure is not limited thereto.

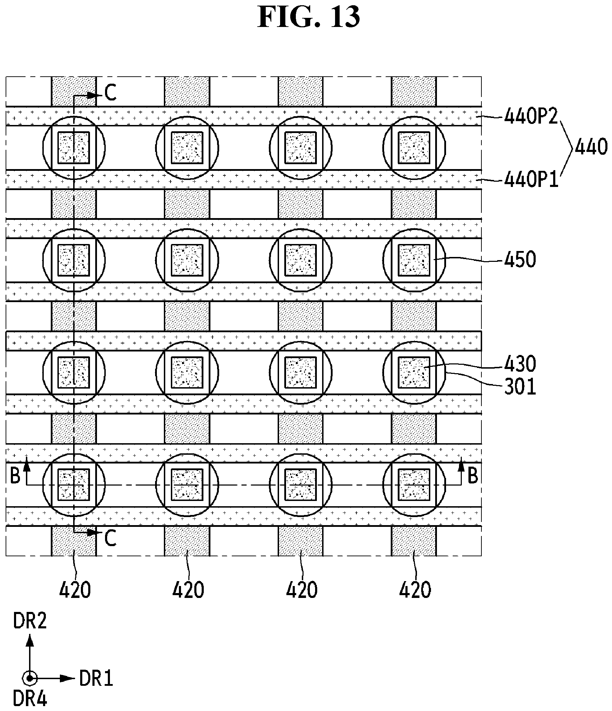

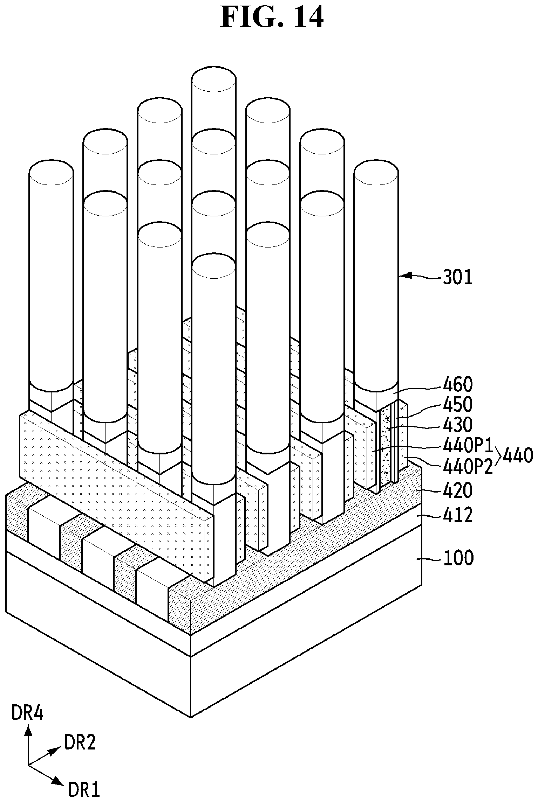

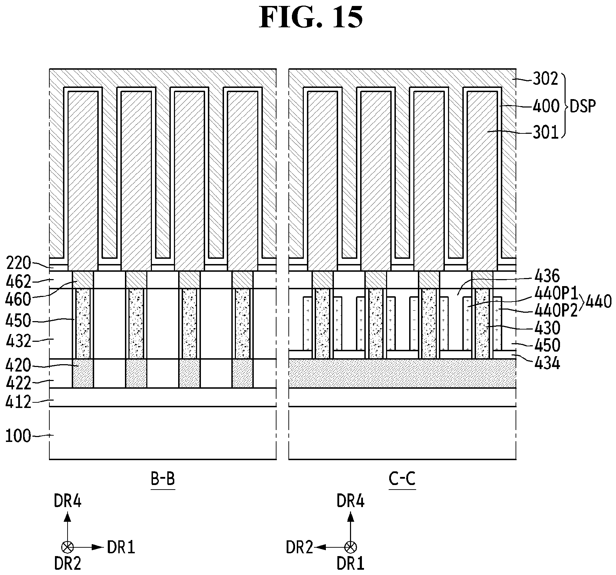

FIG. 13 is a layout view illustrating a semiconductor memory device according to some embodiments. FIG. 14 is a perspective view illustrating the semiconductor memory device of FIG. 13. FIG. 15 is a cross-sectional view taken along lines B-B and C-C of FIG. 13.

For clarity, lower support patterns 141 and upper support patterns 142 are omitted in FIG. 15.

Referring to FIGS. 13 through 15, the semiconductor memory device according to some embodiments may include a substrate 100, a plurality of first conductive lines 420, channel layers 430, gate electrodes 440, gate insulating films 450, and a data storage pattern DSP.

The semiconductor memory device according to some embodiments may be a memory device including vertical channel transistors (VCTs). The VCTs may refer to structures where the channel length of the channel layers 430 extends vertically from the substrate 100.

A lower insulating layer 412 may be disposed on the substrate 100. The first conductive lines 420 may be spaced apart from one another in a first direction DR1 and may extend in a second direction DR2 on the lower insulating layer 412. A plurality of first insulating patterns 422 may be disposed on the lower insulating layer 412 to partially or completely fill the spaces between the first conductive lines 420. The first insulating patterns 422 may extend in the second direction DR2. The upper surfaces of the first insulating patterns 422 may be disposed at the same level as the upper surfaces of the first conductive lines 420. The first conductive lines 420 may function as bitlines.

The first conductive lines 420 may include a doped semiconductor material, a metal, a conductive metal nitride, a conductive metal silicide, a conductive metal oxide, or a combination thereof. For example, the first conductive lines 420 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof, but the present disclosure is not limited thereto. The first conductive lines 420 may include a single layer or a multilayer of the aforementioned materials. In example embodiments, the first conductive lines 420 may include graphene, carbon nanotube, or a combination thereof.

The channel layers 430 may be arranged in a matrix form on the first conductive lines 420 to be spaced apart from one another in the first and second directions DR1 and DR2. The channel layer 430 may have a first width in the first direction DR1 and a first height in a fourth direction DR4, and the first height may be greater than the first width. Here, the fourth direction DR4 may intersect the first and second directions DR1 and DR2 and may be, for example, a direction perpendicular to the upper surface of the substrate 100. The first height may be about 2 to 10 times the first width, but the present disclosure is not limited thereto. Bottom portions of the channel layers 430 may function as third source/drain regions (not illustrated), upper portions of the channel layers 430 may function as fourth source/drain regions (not illustrated), and parts of the channel layers 430 between the third source/drain regions and the fourth source/drain regions may function as channel regions (not illustrated).

For example, the channel layers 430 may include an oxide semiconductor, such as InₓGa_{y}Zn_{z}O, InₓGa_{y}Si_{z}O, InₓSn_{y}Zn_{z}O, InₓZn_{y}O, ZnₓO, ZnₓSn_{y}O, ZnₓO_{y}N, ZrₓZn_{y}Sn_{z}O, SnₓO, HfₓIn_{y}Zn_{z}O, GaₓZn_{y}Sn_{z}O, AlₓZn_{y}Sn_{z}O, YbₓGa_{y}Zn_{z}O, InₓGa_{y}O, or a combination thereof. The channel layers 430 may include a single layer or a multilayer of these oxide semiconductors. In example embodiments, the channel layers 430 may have a bandgap energy greater than that of Si. For example, the channel layers 430 may have a bandgap energy ranging from about 1.5 eV to about 5.6 eV. For example, optimal channel performance may be achieved when the channel layers 430 has a bandgap energy of about 2.0 eV to about 4.0 eV. For example, the channel layers 430 may be polycrystalline or amorphous, but the present disclosure is not limited thereto. In another example, the channel layers 430 may include graphene, carbon nanotube, or a combination thereof. In yet another example, the channel layers 430 may include a Si-series semiconductor material. The channel layers 430 may include a monocrystalline semiconductor material, for example, monocrystalline Si or monocrystalline SiGe, but the present disclosure is not limited thereto.

The gate electrodes 440 may extend in the first direction DR1 along both sidewalls of the channel layers 430. The gate electrodes 440 may include first sub-gate electrodes 440P1, which face first sidewalls of the channel layers 430, and second sub-gate electrodes 440P2, which face second sidewalls of the channel layers 430 that are opposite to the first sidewalls of the channel layers 430. As one channel layer 430 is disposed between first and second sub-gate electrodes 440P1 and 440P2, the semiconductor memory device according to some embodiments may have a dual-gate transistor structure, but the present disclosure is not limited thereto. In some embodiments, the second sub-gate electrodes 440P2 may be omitted, and only the first sub-gate electrodes 440P1 may be formed to face the first sidewalls of the channel layers 430, thereby implementing a single gate transistor structure.

The gate electrodes 440 may include at least one of a metal, a conductive metal nitride, a conductive metal carbonitride, a conductive metal carbide, a metal silicide, a doped semiconductor material, a conductive metal oxynitride, or a conductive metal oxide. The gate electrodes 440 may include, for example, at least one of TiN, TaC, TaN, TiSiN, TaSiN, TaTiN, TiAlN, TaAlN, WN, Ru, TiAl, TiAlC-N, TiAlC, TiC, TaCN, W, Al, Cu, Co, Ti, Ta, Ni, Pt, Ni-Pt, Nb, NbN, NbC, Mo, MoN, MoC, WC, Rh, Pd, Ir, Ag, Au, Zn, V, RuTiN, TiSi, TaSi, NiSi, CoSi, IrOₓ, RuOₓ, and a combination thereof, but the present disclosure is not limited thereto.

The gate insulating films 450 may surround the sidewalls of the channel layers 430 in plan view and may be interposed between the channel layers 430 and the gate electrodes 440. For example, as illustrated in FIG. 8, the entire sidewalls of the channel layers 430 may be surrounded by the gate insulating films 450, and parts of the sidewalls of the gate electrodes 440 may be in contact with the gate insulating films 450. In other embodiments, the gate insulating films 450 may extend in the extension direction of the gate electrodes 440 (i.e., the first direction DR1), and only the sidewalls of the channel layers 430 that face the gate electrodes 440 may be in contact with the gate insulating films 450.

The gate insulating films 450 may include, for example, at least one of silicon oxide, silicon nitride, silicon oxynitride, or a high-K material with a greater dielectric constant than silicon oxide. The high-K material may include, for example, at least one of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate, or a combination thereof.

A plurality of second insulating patterns 432 may extend along the second direction DR2 on the first insulating patterns 422. The channel layers 430 may be disposed between the second insulating patterns 432 that are adjacent to one another. Furthermore, a first fill layer 434 and a second fill layer 436 may be disposed in the spaces between the second insulating patterns 432, between the channel layers 430 that are adjacent to one another. The first fill layer 434 may be disposed at the bottom portions of the spaces between the channel layers 430. The second fill layer 436 may be formed on the first fill layer 434 to fill the rest of the spaces between the channel layers 430. The upper surface of the second fill layer 436 may be disposed at the same level as the upper surfaces of the channel layers 430, and may cover, overlap, or be on the upper surfaces of the second gate electrodes 440. In some embodiments, the second insulating patterns 432 may be formed as a continuous material layer with the first insulating patterns 422, or the second fill layer 436 may be formed as a continuous material layer with the first fill layer 434.

Capacitor contacts 460 may be disposed on the channel layers 430. The capacitor contacts 460 may be disposed to vertically overlap with the channel layers 430 and may be arranged in a matrix form to be spaced apart from one another in the first and second directions DR1 and DR2. The capacitor contacts 460 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, or a combination thereof, but the present disclosure is not limited thereto. An upper insulating layer 462 may surround the sidewalls of the capacitor contacts 460 on the second insulating patterns 432 and the second fill layer 436 in plan view.

A third etch stop film 470 may be disposed on the upper insulating layer 462. The data storage pattern DSP may be disposed on the third etch stop film 470. The data storage pattern DSP may include lower electrodes 301, a capacitor dielectric film structure 400, and an upper electrode 302. The lower electrodes 301 may penetrate the third etch stop film 470 to be electrically connected to the upper surfaces of the capacitor contacts 460.

In example embodiments, the lower electrodes 301 may be disposed to vertically overlap with the capacitor contacts 460 and may be arranged in a matrix form to be spaced apart from one another in the first and second directions DR1 and DR2. In some embodiments, landing pads (not illustrated) may be further disposed between the capacitor contacts 460 and the lower electrodes 301, and the lower electrodes 301 may be arranged in a hexagonal shape.

The lower electrodes 301, the capacitor dielectric film structure 400, and the upper electrode 302 may be substantially the same as their respective counterparts of FIGS. 1 through 7, and thus, detailed descriptions thereof will be omitted.

The lower supporter patterns 141 and the upper supporter patterns 142 are not illustrated in FIG. 15 and may be substantially the same as their respective counterparts of FIGS. 1 through 7.

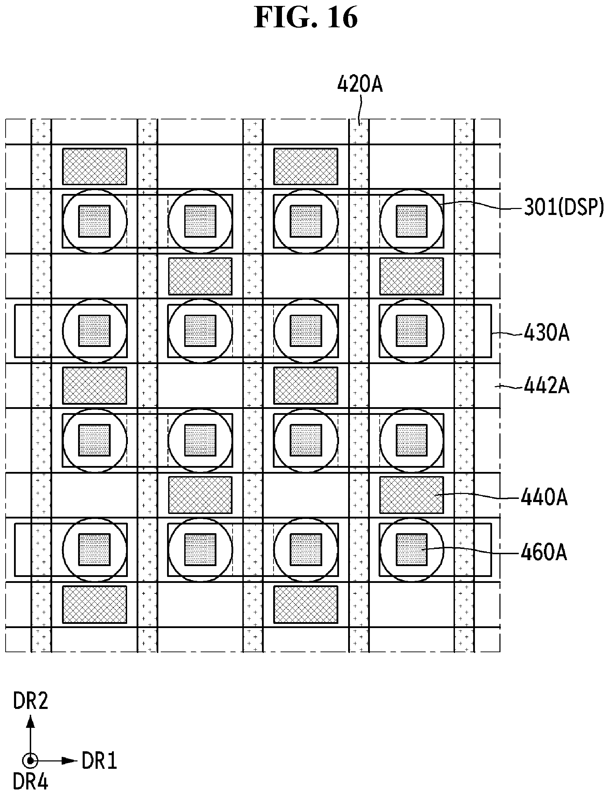

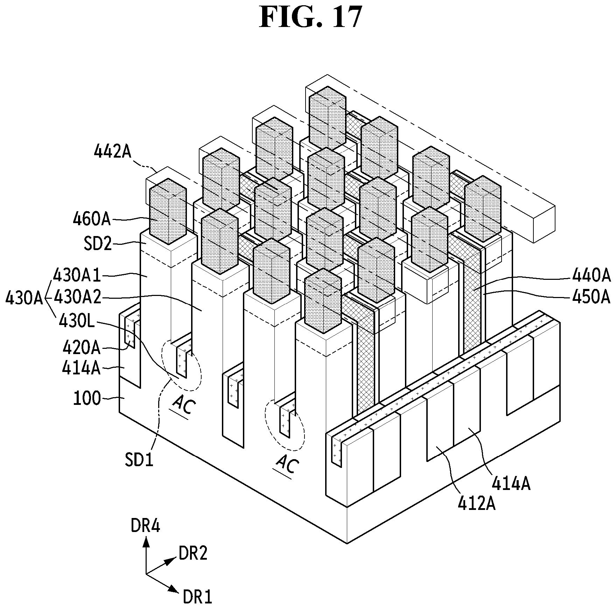

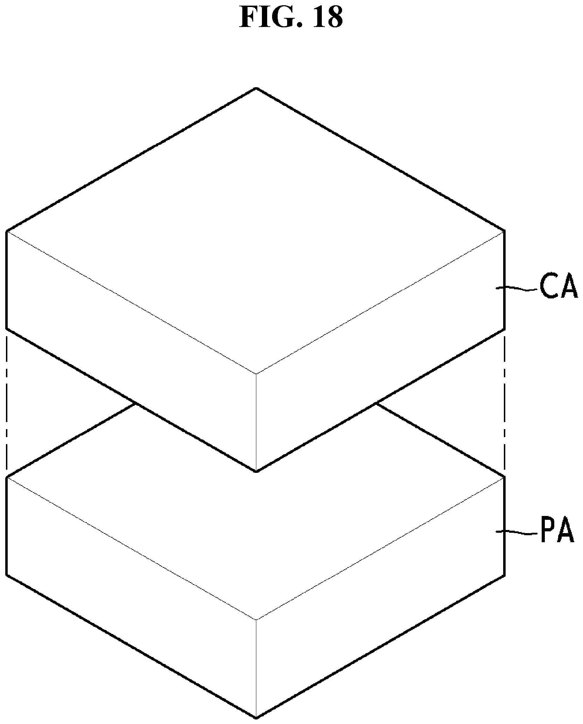

FIG. 16 is a layout view illustrating a semiconductor memory device according to some embodiments. FIG. 17 is a perspective view illustrating the semiconductor memory device of FIG. 16. FIG. 18 is a layout view illustrating a semiconductor memory device according to some embodiments.

Referring to FIGS. 16 and 17, the semiconductor memory device according to some embodiments may include a substrate 100, a plurality of first conductive lines 420A, channel structures 430A, contact gate electrodes 440A, a plurality of second conductive lines 442A, and a data storage pattern DSP. The semiconductor memory device according to some embodiments may be a memory device including VCTs.

A plurality of active areas AC may be defined on the substrate 100 by first device isolation patterns 412A and second device isolation patterns 414A. The channel structures 430A may be disposed within the active areas AC. The channel structures 430A may include first active pillars 430A1 and second active pillars 430A2, which extend in a vertical direction, and connecting portions 430L, which connect the bottom portions of the first active pillars 430A1 and the bottom portions of the second active pillars 430A2. First source/drain regions SD1 may be disposed within the connecting portions 430L. Second source/drain regions SD2 may be disposed on the first active pillars 430A1 and the second active pillars 430A2. The first active pillars 430A1 and the second active pillars 430A2 may form independent unit memory cells.

The first conductive lines 420A may extend in a direction intersecting each of the active areas AC, for example, in a second direction DR2. One of the first conductive lines 420A may be disposed on the connecting portion 430L between first and second active pillars 430A1 and 430A2. One of the first conductive lines 420A may be disposed on the first source/drain region SD1. One of the first conductive line 420A adjacent to one of the first conductive line 420A may be disposed between the two channel structures 430A. One of the first conductive lines 420A may serve as a common bitline for two unit memory cells formed by the first and second active pillars 430A1 and 430A2.

Between two adjacent channel structures 430A in the second direction DR2, one contact gate electrode 440A may be disposed. For example, one contact gate electrode 440A may be disposed between a first active pillar 430A1 of one channel structure 430A and a second active pillar 430A2 of a neighboring channel structure 430A. This contact gate electrode 440A may be shared by the first and second active pillars 430A1 and 430A2 disposed on its both sidewalls. Gate insulating films 450A may be disposed between the gate contact electrode 440A and the first active pillar 430A1 and between the gate contact electrode 440A and the second active pillar 430A2. A plurality of second conductive lines 442A may extend in the first direction D1 on the upper surface of the contact gate electrode 440A. The plurality of second conductive lines 442A may serve as wordlines.

Capacitor contacts 460A may be disposed on the channel structures 430A. The capacitor contacts 460A may be disposed on the second source/drain regions SD2, and the data storage pattern DSP may be disposed on the capacitor contacts 460A.

Referring to FIG. 18, the semiconductor memory device according to some embodiments may have a Cell-on-Peri (COP) structure where a cell array area CA is positioned on a periphery structure area PA.

The cell array area CA may include the VCTs illustrated in FIGS. 13 through 17. In the periphery structure area PA, sensing transistors, transfer transistors, and driving transistors connected to the VCTs of FIGS. 13 through 17 may be disposed.

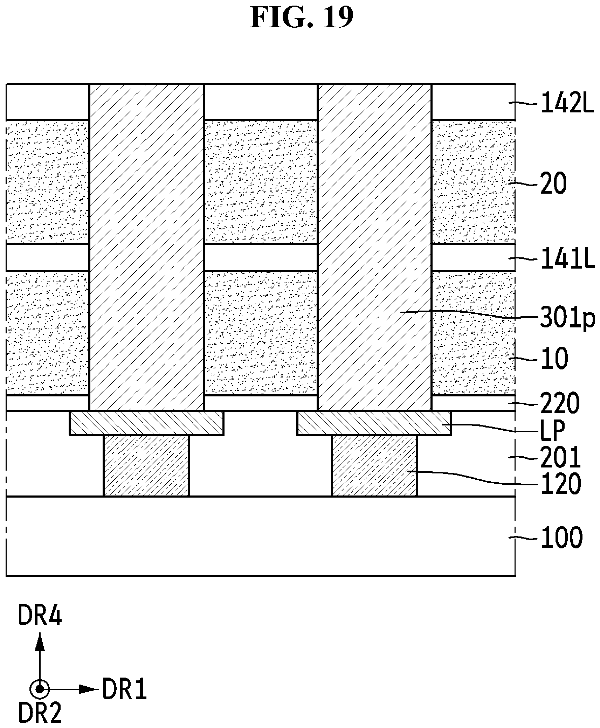

FIGS. 19 through 23 are cross-sectional views illustrating intermediate stages of a method of fabricating a semiconductor memory device according to some embodiments. For convenience, the embodiments of FIGS. 19 through 23 will hereinafter be described, focusing mainly on the differences from what has been described with reference to FIGS. 1 through 7.

Referring to FIG. 19, a first interlayer insulating film 201 may be formed on a substrate 100. Storage contacts 120 and landing pads LP may be formed within the first interlayer insulating film 201. Thereafter, an etch stop film 220, a first mold layer 10, a first supporter layer or first supporter pattern 141L, a second mold layer 20, and a second supporter layer or second supporter pattern142L may be sequentially formed on the first interlayer insulating film 201.

Thereafter, lower electrode patterns 301p, which penetrate the etch stop film 220, the first mold layer 10, the first supporter layer or first supporter pattern 141L, the second mold layer 20, and the second supporter layer or second supporter pattern 142L in a vertical direction or a fourth direction DR4, may be formed on the landing pads LP.

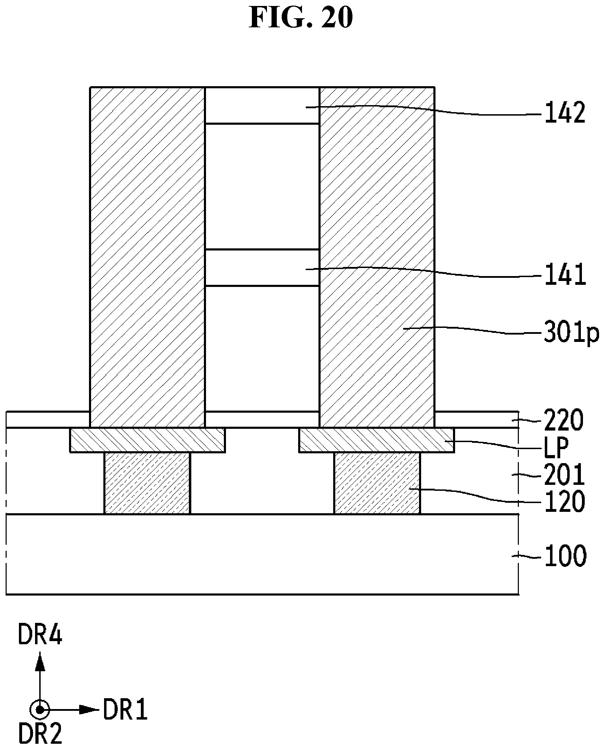

Referring to FIG. 20, first and second supporter patterns 141L and 142L, which connect neighboring lower electrodes 301, may be formed. The first and second supporter patterns 141L and 142L may be in contact with parts of the sidewalls of the lower electrodes 301.

The second supporter pattern 142L may be formed by removing parts of the second supporter layer or second supporter pattern 142L. Through areas where the second supporter pattern 142L is not formed, the second mold layer 20 may be removed. Thereafter, the first supporter pattern 141L may be formed by removing parts of the first supporter layer or first supporter pattern 141L. Through areas where the first supporter pattern 141L is not formed, the first mold layer 10 may be removed. As the first and second mold layers 10 and 20 are removed, the sidewalls of the lower electrode patterns 301p may be exposed. As a result, spaces may be formed between the etch stop film 220 and the first supporter pattern 141L and between the first and second supporter patterns 141L and 142L.

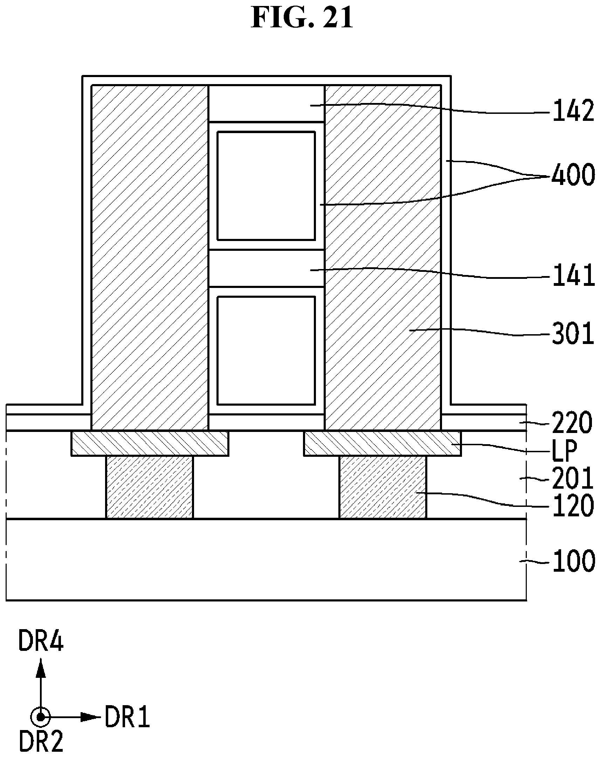

Referring to FIG. 21, a capacitor dielectric film structure 400 may be formed between the exposed etch stop film 220 and the first supporter pattern 141L, and between the first and second supporter patterns 141L and 142L. Specifically, the capacitor dielectric film structure 400 may be formed on the upper surface of the etch stop film 220, the bottom and upper surfaces of the first supporter pattern 141L, and the bottom and upper surfaces of the second supporter pattern 142L.

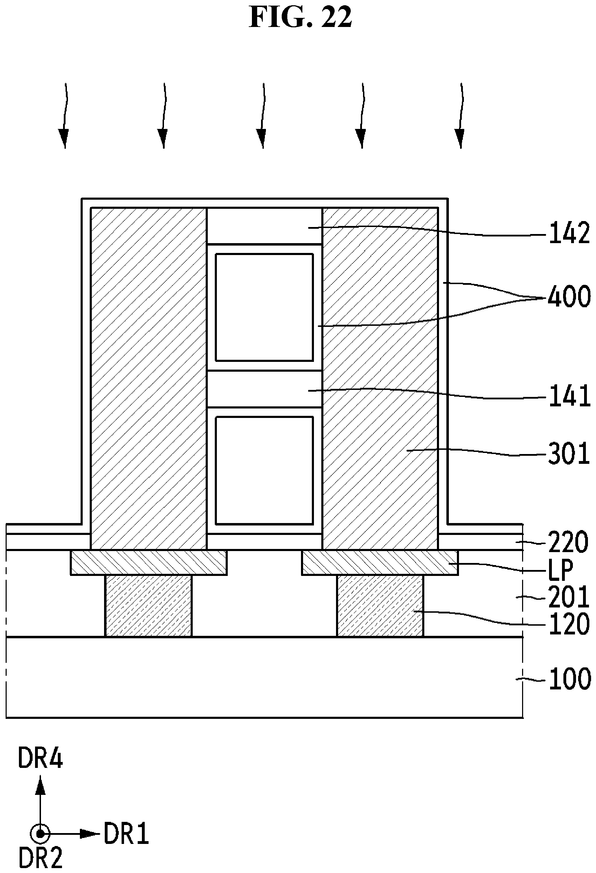

Referring to FIG. 22, after the formation of the capacitor dielectric film structure 400, an annealing process may be performed. The annealing process may be conducted at a temperature of, for example, 200°C to 700°C.

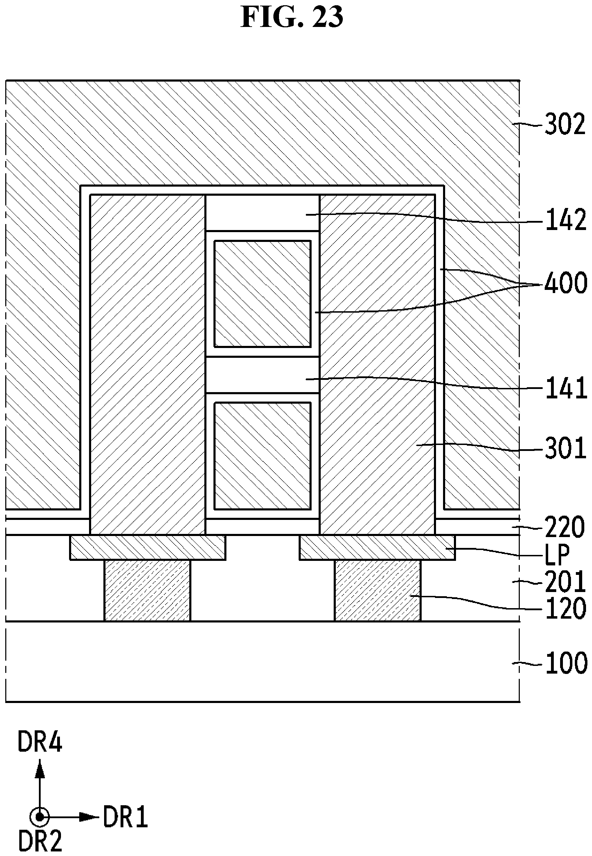

Referring to FIG. 23, after the annealing process, an upper electrode 302 may be formed. The upper electrode 302 may be formed on the capacitor dielectric film structure 400. The upper electrode 302 may be formed to cover or overlap the sidewalls and upper surface of each of the lower electrodes 301. Additionally, the upper electrode 302 may be formed between the etch stop film 220 and the first supporter pattern 141L, and between the first and second supporter patterns 141L and 142L.

FIGS. 22 and 23 illustrate that the upper electrode 302 is formed after the annealing process, but the present disclosure is not limited thereto. In some embodiments, the capacitor dielectric film structure 400 and then the upper electrode 302 may be formed, and then the annealing process may be performed.

Thereafter, referring to FIG. 1, a second interlayer insulating film 202 may be formed on the upper electrode 302, thereby obtaining the semiconductor memory device of FIG. 1.

In concluding the detailed description, those skilled in the art will appreciate that many variations and modifications may be made to the preferred embodiments without substantially departing from the principles of the present inventive concept. Therefore, the disclosed preferred embodiments of the invention are used in a generic and descriptive sense only and not for purposes of limitation.

## Claims

1. A semiconductor memory device comprising:
a first electrode and a second electrode spaced apart from each other; and
a dielectric film structure between the first electrode and the second electrode,
wherein the dielectric film structure includes a first ferroelectric material film, a first insertion film, a second ferroelectric material film, and a first paraelectric material film,
wherein the first ferroelectric material film is closer than the first paraelectric material film to the first electrode, and
wherein a dielectric constant of the first insertion film is greater than respective dielectric constants of the first and second ferroelectric material films.

2. The semiconductor memory device of claim 1, wherein the first insertion film includes an oxide of at least one of zirconium, Zr, titanium, Ti, tantalum, Ta, niobium, Nb, lanthanum, La, barium, Ba, or vanadium, V.

3. The semiconductor memory device of claim 1 or 2, wherein the first insertion film is in direct contact with the first and second ferroelectric material films.

4. The semiconductor memory device of any one of claims 1 to 3, wherein the dielectric constant of a material of the first insertion film is 20 or greater.

5. The semiconductor memory device of any one of claims 1 to 4, wherein a thickness in a first direction of the first insertion film is between 5% and 30% of a sum of respective thicknesses in the first direction of the first and second ferroelectric material films.

6. The semiconductor memory device of any one of claims 1 to 5, wherein the dielectric film structure further includes a second paraelectric material film, which is between the first electrode and the first ferroelectric material film, and
wherein a dielectric constant of the second paraelectric material film is less than the dielectric constant of the first ferroelectric material film.

7. The semiconductor memory device of claim 6, wherein a sum of respective thicknesses in a first direction of the first ferroelectric material film, the first insertion film, and the second ferroelectric material film is less than or equal to 60% of a thickness in the first direction of the dielectric film structure.

8. The semiconductor memory device of claim 6 or 7, wherein the dielectric film structure further includes a third ferroelectric material film and a second insertion film, which are between the second paraelectric material film and the first ferroelectric material film,
wherein the third ferroelectric material film is closer than the second insertion film to the first electrode, and
wherein a dielectric constant of the third ferroelectric material film is greater than the dielectric constant of the second paraelectric material film.

9. The semiconductor memory device of any one of claims 1 to 5, wherein the dielectric film structure further includes a third ferroelectric material film and a second insertion film, which are between the first electrode and the first ferroelectric material film,
wherein the third ferroelectric material film is closer than the second insertion film to the first electrode, and
wherein a dielectric constant of the third ferroelectric material film is greater than a dielectric constant of the first paraelectric material film.

10. The semiconductor memory device of any one of the preceding claims, wherein:
wherein the first and second ferroelectric material films include crystals with an orthorhombic crystal structure, and
wherein the first insertion film includes a material with a dielectric constant that is greater than a dielectric constant of the first paraelectric material film.

11. The semiconductor memory device of any one of claims 1 to 10, wherein the first paraelectric material film has at least one of a monoclinic crystal system or a tetragonal crystal system.

12. The semiconductor memory device of claim 10 or 11, wherein the dielectric film structure further includes a dielectric film which is between the first ferroelectric film and the first electrode, and
wherein the dielectric film has at least one of a monoclinic crystal system or a tetragonal crystal system.

13. The semiconductor memory device of claim 12, wherein the dielectric film is a second paraelectric material film.

14. The semiconductor memory device of any one of the preceding claims, comprising:
a transistor on a substrate; and
a capacitor electrically connected to the transistor,
wherein the capacitor includes the first electrode as a lower electrode, the dielectric film structure on the lower electrode, and the second electrode as an upper electrode on the dielectric film structure.

15. The semiconductor memory device of any one of the preceding claims, wherein the first and second ferroelectric material films include a material with a greater dielectric constant than a dielectric constant of the first paraelectric material film.
